# EUROPEAN PATENT APPLICATION

(11) **EP 4 009 431 A1**
(43) Date of publication of application: **08.06.2022**
(21) Application number: 21209868.5
(22) Date of filing: 23.11.2021
(51) Int. Cl.: H01M 50/287, H01M 50/516, H01M 50/519, H01M 10/04

(54) **WIRED CIRCUIT BOARD FOR BATTERY AND BATTERY MODULE**

(30) Priority: 02.12.2020 JP 2020200452; 09.11.2021 JP 2021182750
(71) Applicant: Nitto Denko Corporation, Ibaraki-shi Osaka 567-8680 (JP)
(72) Inventor: Inoue, Masami, Ibaraki-shi, Osaka, 567-8680 (JP); Yamazaki, Hiroshi, Ibaraki-shi, Osaka, 567-8680 (JP); Tsuda, Hisashi, Ibaraki-shi, Osaka, 567-8680 (JP)
(74) Representative: Hoffmann Eitle

(57) **Abstract**

A wired circuit board for battery 1 includes a stainless steel layer 5, an insulating base layer 6, and a conductor layer 7 sequentially toward one side in the thickness direction. The stainless steel layer 5 is electrically connected to the conductor layer 7. The stainless steel layer 5 includes a first laser weld portion 22 that can be laser welded. The first laser weld portion 22 is exposed to the one side and the other side in the thickness direction.

## Description

### TECHNICAL FIELD

The present invention relates to a wired circuit board for battery and a battery module.

### BACKGROUND ART

Battery modules including a battery, a metal plate, and a printed circuit board sequentially in its thickness direction have been known (for example, see Patent Document 1 cited below). In the battery module described in Patent Document 1, the metal plate is welded, thereby fixing and connecting the printed circuit board to the battery.

### Citation List

### Patent Document

Patent Document 1: Japanese Unexamined Patent Publication No. 2002-329491

### SUMMARY OF THE INVENTION

### PROBLEM TO BE SOLVED BY THE INVENTION

There is a need for downsized battery modules. However, a battery module as described in Patent Document 1 includes a metal plate. Thus, there is a disadvantage that such a module battery cannot meet the above-mentioned need.

The present invention provides a downsized battery module and a wired circuit board for battery included therein.

### MEANS FOR SOLVING THE PROBLEM

The present invention [1] includes a wired circuit board for battery comprising: a stainless steel layer; an insulating base layer; and a conductor layer sequentially toward one side in a thickness direction, wherein the stainless steel layer is electrically connected to the conductor layer, the stainless steel layer includes a laser weld portion that can be laser welded, and the laser weld portion is exposed to the one side and the other side in the thickness direction..

The wired circuit board for battery includes the laser weld portion and thus can be laser welded to the battery module with the laser weld portion. In other words, the wired circuit board for battery does not include a metal plate as described in Patent Document 1. Therefore, the battery module including the wired circuit board for battery can be downsized.

The present invention [2] includes the wired circuit board for battery described in [1] above, wherein the insulating base layer includes an outer peripheral edge, and the laser weld portion protrudes outward from the outer peripheral edge in a direction orthogonal to the thickness direction.

In the wired circuit board for battery, the laser weld portion protrudes outward from the outer peripheral edge. Thus, a step of exposing the laser weld portion is not needed, and the laser weld portion can directly be laser welded.

The present invention [3] includes the wired circuit board for battery described in [2] above, wherein the laser weld portion has a protrusion length of 5 µm or more and 5 mm or less.

The wired circuit board for battery has a protrusion length of 5 mm or less. Thus, the wired circuit board for battery can be downsized. In the wired circuit board for battery, the protrusion length is 5 µm or more. Thus, the laser weld portion can surely be laser welded. Therefore, a battery module excellent in reliability can be produced.

The present invention [4] includes the wired circuit board for battery described in [2] or [3] above, wherein the stainless steel layer has a slit around the laser weld portion.

In the wired circuit board for battery, the stainless steel layer and the insulating base layer include the slit. Thus, when the laser weld portion is laser welded, deformation of the stainless steel layer and insulating base layer by the heat of the laser welding can be suppressed.

The present invention [5] includes the wired circuit board for battery described in [1] above, wherein the insulating base layer has an opening penetrating the insulating base layer in the thickness direction, and the laser weld portion is exposed from the opening to the one side in the thickness direction.

In the wired circuit board for battery, the laser weld portion is exposed from the opening. Thus, a step of exposing the laser weld portion is not needed, and the laser weld portion can directly be laser welded.

The present invention [6] includes the wired circuit board for battery described in [5] above, wherein the laser weld portion has an exposed area of 25 mm2 or less.

In the wired circuit board for battery, the laser weld portion has an exposed area of 25 mm2 or less. Thus, the wired circuit board for battery can be downsized.

The present invention [7] includes the wired circuit board for battery described in [5] or [6] above, wherein the stainless steel layer and the insulating base layer have a slit disposed around the opening.

In the wired circuit board for battery, the stainless steel layer includes the slit. Thus, when the laser weld portion is laser welded, deformation of the stainless steel layer by the heat of the laser welding can be suppressed.

The present invention [8] includes a battery module comprising: the wired circuit board for battery described in any one of [1] to [7] above; and a battery including an electrode welded to the laser weld portion.

The battery module is downsized because including the above-described wired circuit board for battery.

### EFFECTS OF THE INVENTION

The battery module including the wired circuit board for battery of the present invention is downsized.

### BRIEF DESCRIPTION OF THE DRAWINGS

[FIG. 1] FIG. 1 is a plan view of an embodiment of the wired circuit board for battery of the present invention.
[FIG. 2] FIG. 2 is a cross-sectional view taken along line X-X of the wired circuit board for battery illustrated in FIG. 1.
[FIG. 3] FIG. 3 is a perspective view of the battery module including the wired circuit board for battery illustrated in FIG. 1 and FIG. 2.
[FIG. 4] FIG. 4 is a cross-sectional view of the battery module along the dotted line of FIG. 3.
[FIG. 5] FIG. 5 is a plan view of a variation of the wired circuit board for battery illustrated in FIG. 1.
[FIG. 6] FIG. 6A and FIG. 6B are enlarged views of the first laser weld portion of the wired circuit board for battery of a variation. FIG. 6A is a plan view thereof. FIG. 6B is a cross-sectional view taken along line X-X of FIG. 6A.
[FIG. 7] FIG. 7A and FIG. 7B are enlarged views of the first laser weld portion of the wired circuit board for battery of a variation. FIG. 7A is a plan view thereof. FIG. 7B is a cross-sectional view taken along line Y-Y of FIG. 7A.
[FIG. 8] FIG. 8A and FIG. 8B are enlarged views of the second laser weld portion of the wired circuit board for battery of a variation. FIG. 8A is a plan view thereof. FIG. 8B is a cross-sectional view taken along line X-X of FIG. 8A.
[FIG. 9] FIG. 9A and FIG. 9B are enlarged views of the second laser weld portion of the wired circuit board for battery of a variation. FIG. 9A is a plan view thereof. FIG. 9B is a cross-sectional view taken along line Y-Y of FIG. 9A.

### DESCRIPTION OF THE EMBODIMENTS

### <Embodiment>

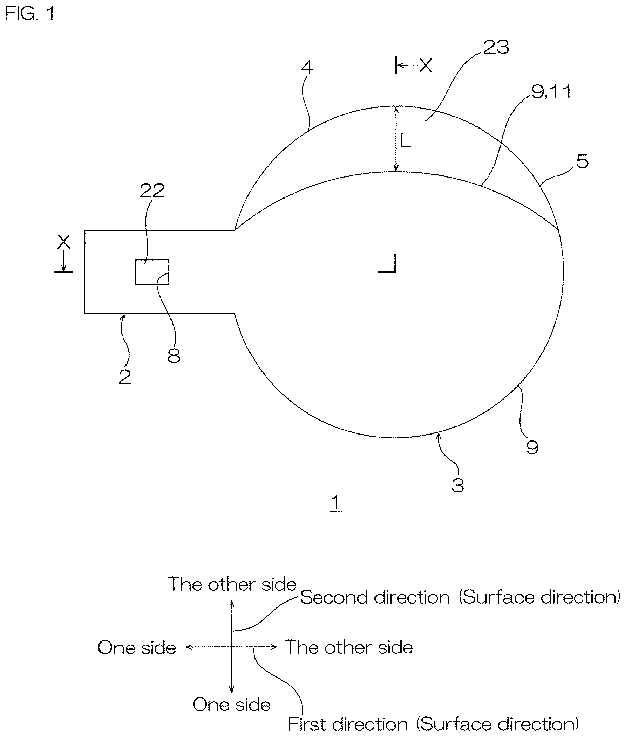

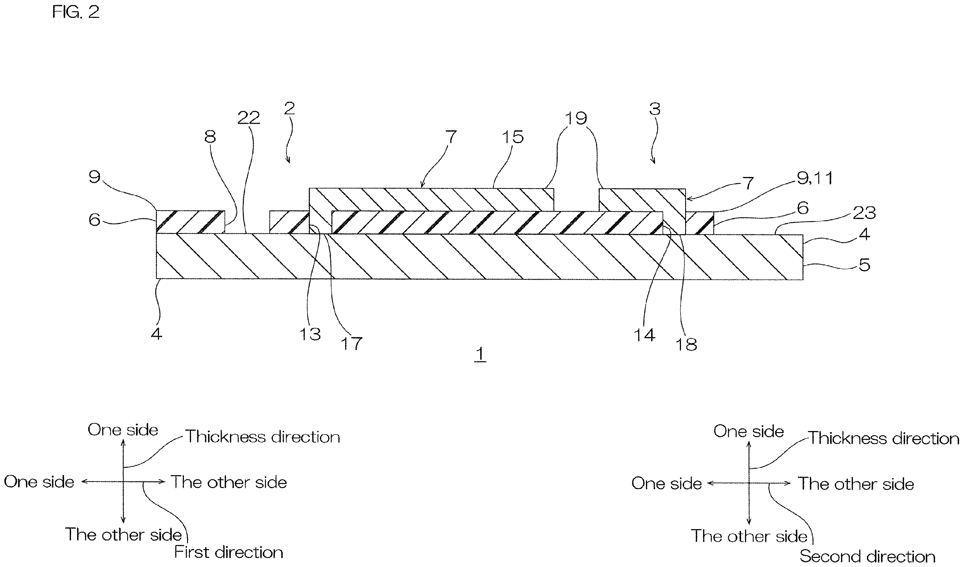

An embodiment of the wired circuit board of the present invention is described with reference to FIG. 1 and FIG. 2. To clarify the shapes and dispositions of a first laser weld portion 22 and a second laser weld portion 23 (both described below) in a wired circuit board for battery 1 (described below), a conductor layer 7 (described below) is omitted in FIG. 1.

The wired circuit board for battery 1 extends in a surface direction orthogonal to a thickness direction. The wired circuit board for battery 1 includes a first portion 2 and a second portion 3 sequentially in the surface direction.

The shape and dimensions of the first portion 2 are not especially limited. The first portion 2 has, for example, an approximately rectangular shape in the plan view. The first portion 2 extends in a first direction. The first direction is included in the surface direction.

The second portion 3 continues to the other edge in the first direction of the first portion 2. The second portion 3 extends from the other edge in the first direction of the first portion 2 to the other side in the first direction. The shape and dimensions of the second portion 3 are not especially limited. The second portion 3 has, for example, an approximately circular shape in the plan view.

The wired circuit board for battery 1 includes a stainless steel layer 5, an insulating base layer 6And the conductor layer 7 sequentially toward one side in the thickness direction. Each of the stainless steel layer 5, insulating base layer 6And conductor layer 7 traverses the first portion 2 and second portion 3.

The stainless steel layer 5 forms the outermost surface at the other side in the thickness direction of the wired circuit board for battery 1. In other words, the stainless steel layer 5 is exposed toward the other side in the thickness direction. The stainless steel layer 5 extends in the surface direction. When being projected in the thickness direction, an outer peripheral edge 4 of the stainless steel layer 5 may correspond to an outer peripheral edge of the wired circuit board for battery 1. The stainless steel layer 5 has a thickness of, for example, 5 µm or more, preferably, 10 µm or more and, for example, 200 µm or less, preferably, 100 µm or less.

In the first portion 2, the insulating base layer 6 has a base opening 8 as an exemplary opening penetrating the insulating base layer 6 in the thickness direction. The base opening 8 exposes a one-side surface in the thickness direction of the stainless steel layer 5 in the first portion 2. The portion of the stainless steel layer 5 exposed from the base opening 8 is the first laser weld portion 22 as an exemplary laser weld portion. A one-side surface and the other-side surface in the thickness direction of the first laser weld portion 22 are exposed to one side and the other side in the thickness direction, respectively. The first laser weld portion 22 is, for example, 25 mm2 or less, preferably, 10 mm2 or less, more preferably, 1 mm2 or less and, for example, 1 µm2 or more in area. The area is the area of the one-side surface in the thickness direction of the first laser weld portion 22, namely, the exposed area of the first laser weld portion 22. When the area is the above-described upper limit or less, the wired circuit board for battery 1 can be downsized. In the first portion 2, an outer peripheral edge 9 of the insulating base layer 6 may correspond to the outer peripheral edge 4 of the stainless steel layer 5 when being projected in the thickness direction.

In the second portion 3, the outer peripheral edge 9 of the insulating base layer 6 includes a displaced portion 11. When being projected in the thickness direction, the displaced portion 11 is displaced to one side in the second direction with respect to the other-side end in the second direction of the outer peripheral edge 4 of the stainless steel layer 5. The second direction is included in the surface direction and orthogonal to the first direction. The portion of the stainless steel layer 5 disposed at the other side in the second direction with respect to the displaced portion 11 (an example of the outside) is the second laser weld portion 23 as an exemplary laser weld portion. The second laser weld portion 23 protrudes from the displaced portion 11 of the insulating base layer 6 to the other side in the second direction. In the present embodiment, the second laser weld portion 23 has an approximately arched shape in the plan view (or an approximately crescent shape in the plan view).

The second laser weld portion 23 has (a maximum value L of) a second direction length, or, (the maximum value of) a protrusion length of, for example, 5 µm or more, preferably, 10 µm or more and, for example, 5 mm or less, preferably, 2 mm or less. When the protrusion length is the above-described upper limit or less, the wired circuit board for battery 1 can be downsized. When the protrusion length is the above-described lower limit or more, the second laser weld portion 23 can surely be laser welded. Thus, a battery module 20 with excellent reliability can be produced.

As illustrated in FIG. 2, the insulating base layer 6 further has a second opening 13 and a third opening 14. Each of the second opening 13 and third opening 14 penetrates the insulating base layer 6 in the thickness direction.

Examples of the material of the insulating base layer 6 include resin. Examples of the resin include polyimide. The insulating base layer 6 has a thickness of, for example, 1 µm or more and, for example, 50 µm or less.

The conductor layer 7 traverses the first portion 2 and second portion 3. The conductor layer 7 is disposed on a one-side surface in the thickness direction of the insulating base layer 6. The conductor layer 7 includes a conductor pattern 15. The conductor pattern 15 includes a first connection portion 17, a second connection portion 18, and a terminal 19. The second opening 13 is filled with the first connection portion 17. The other-side surface in the thickness direction of the first connection portion 17 is in contact with the one-side surface in the thickness direction of the stainless steel layer 5. The third opening 14 is filled with the second connection portion 18. The other-side surface in the thickness direction of the second connection portion 18 is in contact with the one-side surface in the thickness direction of the stainless steel layer 5. The terminal 19 is electrically connected to the stainless steel layer 5 via the first connection portion 17 and second connection portion 18. Examples of the material of the conductor layer 7 include a conductor. Examples of the conductor include copper. The conductor layer 7 has a thickness of, for example, 1 µm or more and, for example, 50 µm or less. The thickness of the conductor layer 7 is a distance between the one-side surface in the thickness direction of the insulating base layer 6And a one-side surface in the thickness direction of the conductor layer 7.

A method of producing the wired circuit board for battery 1 is described. First, the stainless steel layer 5 is prepared. Next, the insulating base layer 6 is disposed. For example, varnish including resin is applied and dried, thereby forming the insulating base layer 6. Thereafter, the conductor layer 7 is disposed. For example, by an additive method or a subtractive method, the conductor layer 7 is formed. In this manner, the wired circuit board for battery 1 is produced.

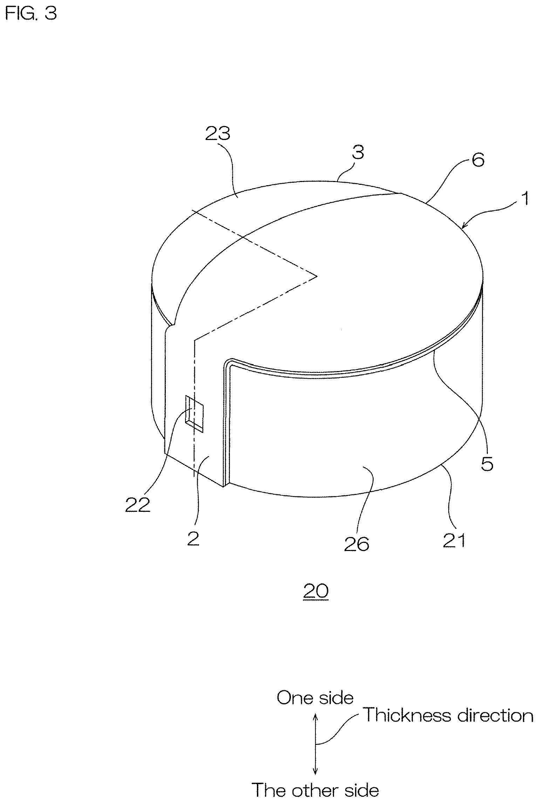

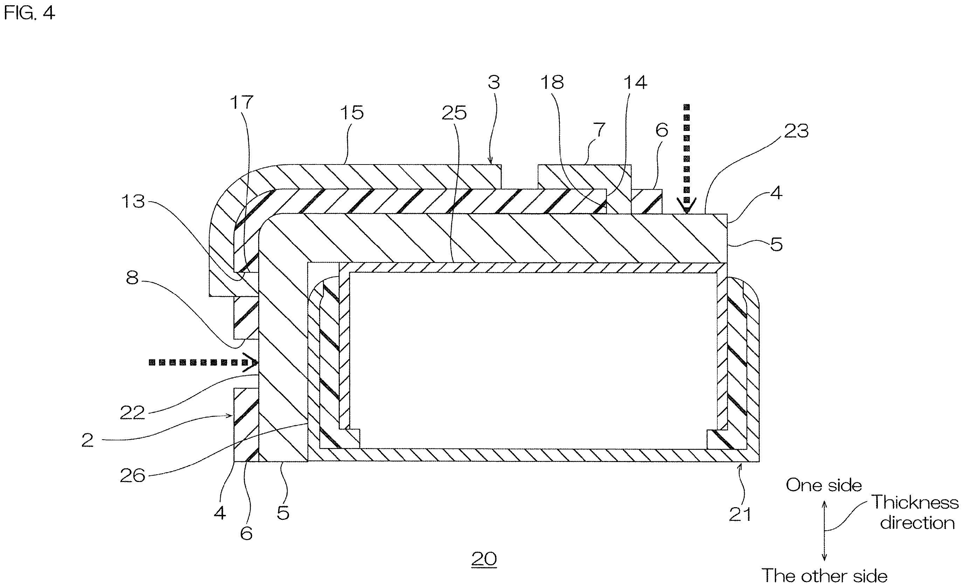

The wired circuit board for battery 1 is, for example, as illustrated in FIG. 3 and FIG. 4, included in the battery module 20. The battery module 20 includes a battery 21 and the wired circuit board for battery 1.

The battery 21 has an approximately cylindrical shape. The battery 21 has a flat shape. The axis-direction length of the battery 21 is, for example, shorter than its diameter. In short, the battery 21 has a button shape. Examples of the battery 21 include a primary battery, and a secondary battery. The battery 21 has a one-side surface and the other-side surface in the thickness direction, and a peripheral surface connecting a peripheral edge of the one-side surface and a peripheral edge of the other-side surface. The battery 21 includes a negative terminal 25 as an exemplary electrode and a positive terminal 26As an exemplary electrode.

The negative terminal 25 forms the one-side surface in the thickness direction of the battery 21. The above-described second laser weld portion 23 of the wired circuit board for battery 1 is laser welded to the negative terminal 25.

The positive terminal 26 forms at least a side surface (specifically, the side surface and the other-side surface) of the battery 21. The first laser weld portion 22 of the above-described wired circuit board for battery 1 is laser welded to the positive terminal 26.

A method of producing the battery module 20 is described. First, the battery 21 and wired circuit board for battery 1 are prepared. Next, the wired circuit board for battery 1 is folded so that the boundary between the first portion 2 and second portion 3 forms a valley (folded portion). The stainless steel layer 5 on the first portion 2 and the stainless steel layer 5 on the second portion 3 of the folded wired circuit board for battery 1 are brought into contact with the positive terminal 26And negative terminal 25, respectively.

Thereafter, the first laser weld portion 22 and second laser weld portion 23 are irradiated with a laser beam to weld the first laser weld portion 22 to the positive terminal 26And the second laser weld portion 23 to the negative terminal 25, respectively.

Specifically, a laser beam is delivered from a lateral side of the battery module 20 to the first laser weld portion 22. Meanwhile, a laser beam is delivered from the one side in the thickness direction of the battery module 20 to the second laser weld portion 23. The conditions for the laser irradiation are not especially limited.

### <Use of the battery module 20 >

The battery module 20 is used for, for example, a wireless power transmission device, or a wearable device. Examples of the wireless power transmission device include a small device. Specific examples of the small device include a hearing aid.

### <Operations and effects of the embodiment

The wired circuit board for battery 1 includes the first laser weld portion 22 and second laser weld portion 23, and can be laser welded to the negative terminal 25 and positive terminal 26 of the battery 21 with the first laser weld portion 22 and second laser weld portion 23. The battery module 20 does not include a metal plate as described Patent Document 1. Thus, the battery module 20 including the wired circuit board for battery 1 can be downsized.

In the wired circuit board for battery 1, the second laser weld portion 23 protrudes from the outer peripheral edge 9 of the insulating base layer 6 to the other side in the second direction. Thus, a step of exposing the second laser weld portion 23 is not needed. Therefore, the second laser weld portion 23 can directly be welded.

When (the maximum value of) the protrusion length of the second laser weld portion 23 is 5 mm or less, the wired circuit board for battery 1 can be downsized. When (the maximum value of) the protrusion length of the second laser weld portion 23 is 5 µm or more, the second laser weld portion 23 can surely be laser welded. Thus, a battery module with excellent reliability can be produced.

Similarly, in the wired circuit board for battery 1, the first laser weld portion 22 is exposed from the base opening 8. Thus, a step of exposing the first laser weld portion 22 is not needed. Therefore, the first laser weld portion 22 can directly be welded.

When the exposed area of the first laser weld portion 22 is 25 mm2 or less, the wired circuit board for battery 1 can be downsized.

The battery module 20 including the small wired circuit board for battery 1 is downsized.

### <Variation>

In the following variation, the same members and steps as in the above-described embodiment are given the same numerical references and the detailed descriptions thereof are omitted. Further, the variation has the same operations and effects as those of the embodiment unless especially described otherwise. Furthermore, the embodiment and variation can appropriately be combined.

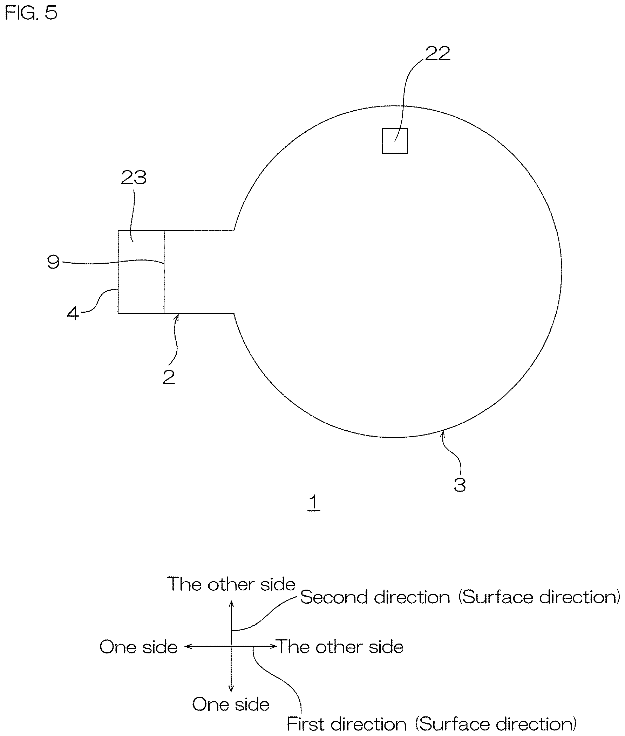

In the embodiment, the first portion 2 includes the first laser weld portion 22, and the second portion 3 includes the second laser weld portion 23. In the variation, as illustrated in FIG. 5, a second portion 3 includes a first laser weld portion 22. A first portion 2 includes a second laser weld portion 23. Although not illustrated, the first portion 2 can include the first laser weld portion 22 and second laser weld portion 23. Although not illustrated, the second portion 3 can include the first laser weld portion 22 and second laser weld portion 23.

A stainless steel layer 5 can include one of the first laser weld portion 22 and second laser weld portion 23.

Although not illustrated, the stainless steel layer 5 can have an island. On the stainless steel layer 5, the island is separated from its peripheral portions with a space, and insulated. The island overlaps a second opening 13 or a third opening 14 of an insulating base layer 6.

Although not illustrated, the wired circuit board for battery 1 may include a cover insulating layer covering a conductor pattern 15.

Although not illustrated, the stainless steel layer 5 electrically connected to a first connection portion 17 may be laser welded to a negative terminal 25. The stainless steel layer 5 electrically connected to a second connection portion 18 may be laser welded to a positive terminal 26Both of the stainless steel layer 5 electrically connected to the first connection portion 17 and stainless steel layer 5 electrically connected to the second connection portion 18 may be laser welded to the stainless steel layer 5 or to the positive terminal 26.

Although not illustrated, the wired circuit board for battery 1 may include only one of the first portion 2 and second portion 3.

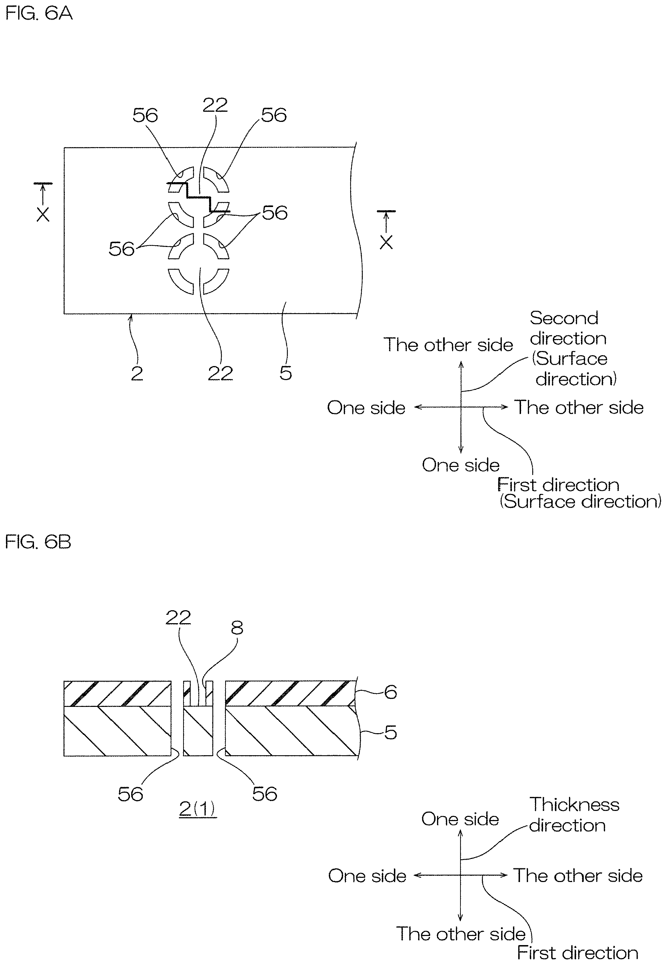

As illustrated in FIG. 6A and FIG. 6B, this variation demonstrates that a stainless steel layer 5 and an insulating base layer 6 (see FIG. 6B) include a slit 56. In FIG. 6A, the insulating base layer 6 is omitted. As illustrated in FIG. 6B, the slit 56 is disposed around the base opening 8. The slit 56 penetrates the stainless steel layer 5 and the insulating base layer 6 in the thickness direction. This variation demonstrates that the slit 56 has an approximately arc shape. A plurality (four) of the slits 56 is disposed with a space therebetween in a circumferential direction of the base opening 8. The plurality of slits 56 intermittently forms an approximately ringed shape in the circumferential direction. The ratio of the area of the slits 56 to the opening area of the base opening 8 (the area of the first laser weld portion 22) is, for example, 0.1 or more and, for example, 0.9 or less.

The first portion 2 includes a plurality (two) of the first laser weld portions 22 (the base openings 8, see FIG. 6B). The first laser weld portions 22 are arranged in the second direction. The first laser weld portions 22 are separated with a space therebetween in the second direction. Each of the first laser weld portions 22 is provided with the above-described plurality (four) of slits 56.

In the variation illustrated in FIG. 6A and FIG. 6B, the stainless steel layer 5 and the insulating base layer 6 include the slits 56. Thus, when the first laser weld portions 22 are laser welded, deformation of the stainless steel layer 5 and insulating base layer 6 by the heat of the laser welding can be suppressed. The deformation includes, for example, a crease.

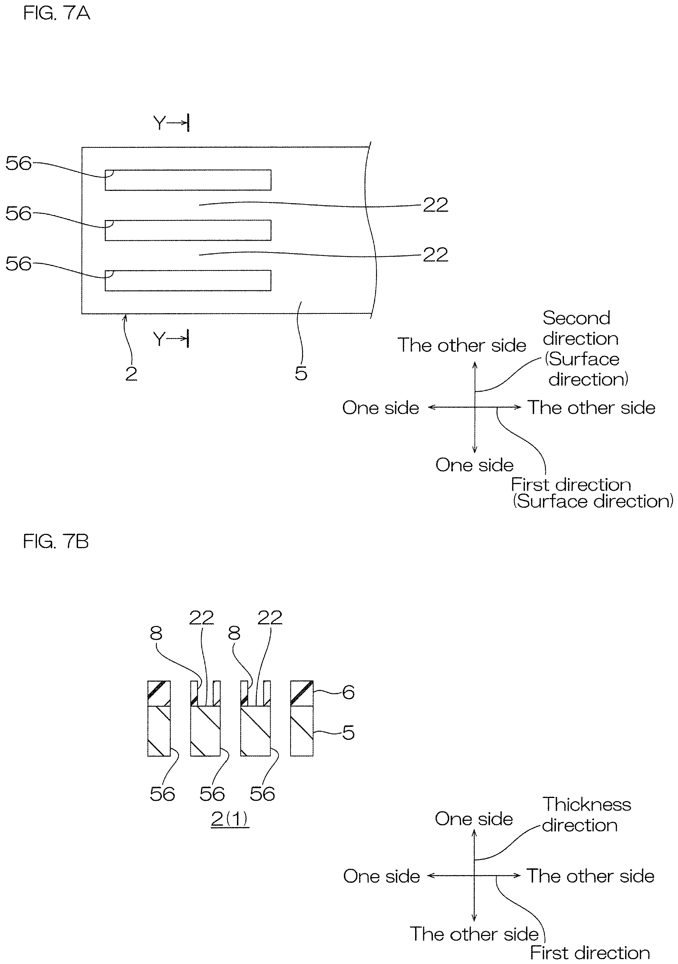

In the variation illustrated in FIG. 7A and FIG. 7B, a slit 56 has an approximately straight line shape in the plan view. The slits 56 extend in the first direction. The slits 56 are separated with a space therebetween in the second direction.

As illustrated in FIG. 7B, a base opening 8 is surrounded by the slits 56. This variation demonstrates that two base openings 8 are provided among three slits 56.

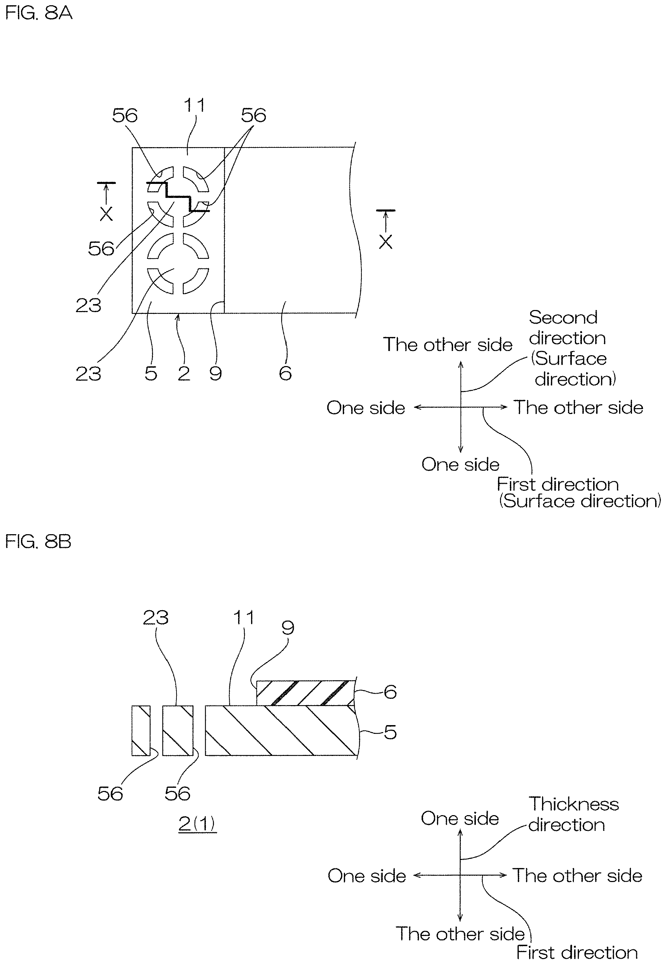

As illustrated in FIG. 8A and FIG. 8B, this variation demonstrates that a stainless steel layer 5 includes a slit 56 in a first portion 2. An insulating base layer 6 does not include a slit 56. As illustrated in FIG. 8B, a plurality of slits 56 define the second laser weld portion 23. The second laser weld portion 23 is disposed inside a plurality of slits 56. The plurality of slits 56 intermittently forms an approximately ringed shape in the circumferential direction. The region of the second laser weld portion 23 is a region surrounded by the plurality of slits 56. The ratio of the area of the slits 56 to the area of the second laser weld portion 23 is, for example, 0.1 or more and, for example, 0.9 or less.

The first portion 2 includes a plurality (two) of second laser weld portions 23. The second laser weld portions 23 are arranged in the second direction. The second laser weld portions 23 are separated with a space therebetween in the second direction. Each of the second laser weld portions 23 is provided with the plurality (four) of slits 56.

In the variation illustrated in FIG. 8A and FIG. 8B, the stainless steel layer 5 includes the slits 56. Thus, when the second laser weld portions 23 are laser welded, deformation of the stainless steel layer 5 by the heat of the laser welding can be suppressed. The deformation includes, for example, a crease.

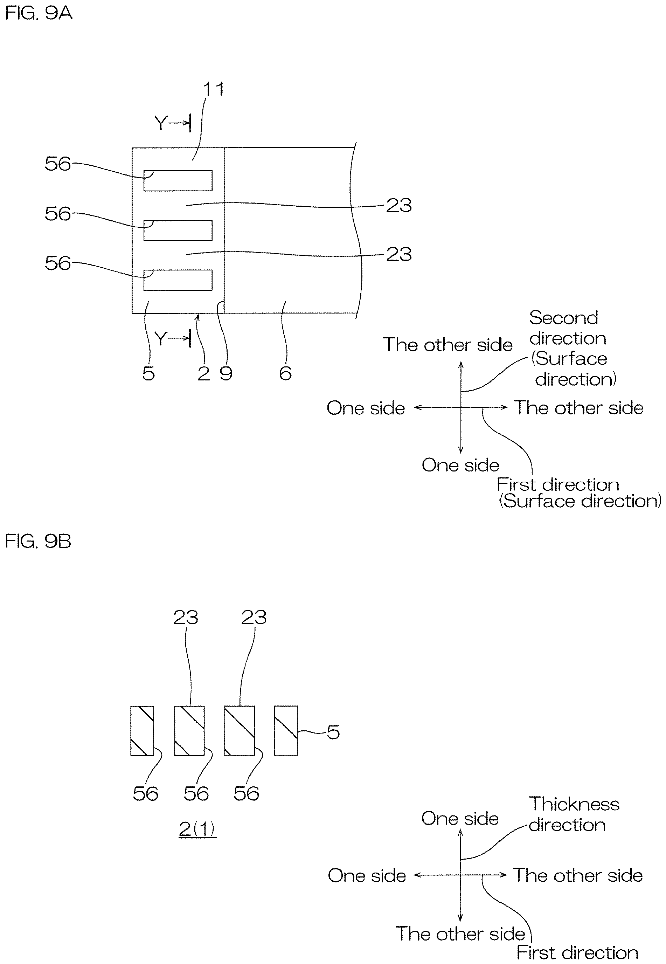

As illustrated in FIG. 9A and FIG. 9B, the second laser weld portions 23 are surrounded by a plurality of slits 56 having an approximately straight line shape in the plan view. While the illustrative embodiments of the present invention are provided in the above description, such is for illustrative purpose only and it is not to be construed as limiting in any manner. Modification and variation of the present invention that will be obvious to those skilled in the art is to be covered by the following claims.
- 1: wired circuit board for battery
- 4: outer peripheral edge
- 5: stainless steel layer
- 6: insulating base layer
- 8: base opening
- 7: conductor layer
- 9: outer peripheral edge
- 19: terminal
- 20: battery module
- 21: battery
- 56: slit

## Claims

1. A wired circuit board for battery comprising:
a stainless steel layer; an insulating base layer; and a conductor layer sequentially toward one side in a thickness direction,
wherein the stainless steel layer is electrically connected to the conductor layer,
the stainless steel layer includes a laser weld portion that can be laser welded, and
the laser weld portion is exposed to the one side and the other side in the thickness direction.

2. The wired circuit board for battery according to Claim 1, wherein the insulating base layer includes an outer peripheral edge, and
the laser weld portion protrudes outward from the outer peripheral edge in a direction orthogonal to the thickness direction.

3. The wired circuit board for battery according to Claim 2, wherein the laser weld portion has a protrusion length of 5 µm or more and 5 mm or less.

4. The wired circuit board for battery according to Claim 2 or 3, wherein the stainless steel layer has a slit disposed around the laser weld portion.

5. The wired circuit board for battery according to Claim 1, wherein the insulating base layer has an opening penetrating the insulating base layer in the thickness direction, and
the laser weld portion is exposed from the opening to the one side in the thickness direction.

6. The wired circuit board for battery according to Claim 5, wherein the laser weld portion has an exposed area of 25 mm² or less.

7. The wired circuit board for battery according to Claim 5 or 6, wherein the stainless steel layer and the insulating base layer have a slit disposed around the opening.

8. A battery module comprising:
the wired circuit board for battery according to any one of Claims 1 to 7; and
a battery including an electrode welded to the laser weld portion.
